# EUROPÄISCHE PATENTSCHRIFT

(11) **EP 1 605 737 B1**
(45) Veröffentlichungstag und Bekanntmachung des Hinweises auf die Patenterteilung: **21.07.2010**
(21) Anmeldenummer: 05012007.0
(22) Anmeldetag: 03.06.2005
(51) Int. Cl.: H05K 3/26

(54) **Verfahren zur zumindest dreistufigen Säuberung durch Reinigen, Spülen und Trocknen, von im Wesentlichen flächigen Gegenständen**
Process in at least three steps for cleaning of substantially flat items by cleaning, rinsing and drying.
Méthode consistant au minimum en trois étapes pour le nettoyage d'éléments essentiellement plats par nettoyage, rinçage et séchage.

(30) Priorität: 07.06.2004 DE 202004009010 U
(43) Veröffentlichungstag der Anmeldung: 14.12.2005
(73) Patentinhaber: kolb Cleaning Technology GmbH, 47877 Willich (DE)
(72) Erfinder: Pollmann, Georg, 47877 Willich (DE)
(74) Vertreter: DR. STARK & PARTNER

(56) Entgegenhaltungen:
- EP-A- 0 368 775
- WO-A-92/21451
- DE-A1- 3 333 221
- DE-U1- 20 103 822
- US-A- 5 564 159
- "AQUEOUS CLEANING VERTICAL METHOD" IBM TECHNICAL DISCLOSURE BULLETIN, IBM CORP. NEW YORK, US, Bd. 34, Nr. 7B, 1. Dezember 1991 (1991-12-01), Seiten 469-471, XP000282649 ISSN: 0018-8689

## Beschreibung

Die Erfindung betrifft eine Verfahren zur zumindest dreistufigen Säuberung durch Reinigen, Spülen und Trocknen von im Wesentlichen flächigen Gegenständen, insbesondere von Siebschablonen und von mit elektronischen Bauteilen bestückten Leiterplatten, mit zumindest einem auf zumindest einer Seite des Gegenstandes im Abstand zu der zu säubernden Oberfläche des Gegenstandes angeordneten Arm, der zur Erfassung der gesamten zu säubernden Oberfläche flächig verteilte und/oder in ihrer Position oder Ausrichtung veränderbare und in etwa in Richtung des Gegenstandes weisende Austrittsöffnungen aufweist, wobei Austrittsöffnungen für die einzelnen Säuberungsstufen vorgesehen sind.

Bekannte Vorrichtungen weisen ein Gehäuse auf, in dem die zu reinigenden Gegenstände vertikal in geeigneten Halterungen angeordnet sind. Bei den Gegenständen kann es sich beispielsweise um Siebschablonen, die zur Herstellung von Leiterplatten verwendet werden, oder um mit Bauteilen bestückte Leiterplatten handeln. Es sind aber auch andere im Wesentlichen flächig ausgebildete Gegenstände denkbar. Die zu reinigenden Gegenstände können auch in einem Carrier oder einem Waschrahmen fixiert werden, der dann wiederum in die entsprechende Halterung eingesetzt wird.

Beidseits des zu reinigenden Gegenstandes ist eine Anordnung von je drei Armen vorgesehen, wobei ein Arm zum Aufbringen der Reinigungsflüssigkeit, ein Arm zum Aufbringen der Spülflüssigkeit und ein weiterer Arm zum Aufblasen von Druckluft vorgesehen ist. Die Arme sind dabei horizontal angeordnet, wobei jede Anordnung in seiner Gesamtheit translatorisch entlang des Gegenstandes verfahren wird.

Nachteilig hierbei ist, dass einerseits die Konstruktion aufgrund der vielen Bauteile aufwendig ist und andererseits die Abdichtung des Gehäuses, da die Arme endseitig aus diesem herausragen und an einer außerhalb des Gehäuses befindlichen Kette befestigt sind, problematisch ist.

In bekannten Säuberungsverfahren wird der zu säubernde Gegenstand entweder in einer aus Dokument DE-U1-201 03 822 bekannten Einkammeranlage, in der sämtliche Säuberungsstufen hintereinander ablaufen, oder in einer aus entweder Dokument DE-A1-33 33 221 oder Dokument US-A-5 564 159 bekannten Mehrkammeranlage, was ein Umsetzen des zu säubernden Gegenstandes erforderlich macht, zunächst mit einer Reinigungsflüssigkeit gereinigt, einer Spülflüssigkeit gespült und im Anschluss daran getrocknet. Hierzu wird Warmluft verwendet, die über einen Lüfter zugeführt wird. Diese Trocknungsart ist recht energieintensiv und insbesondere bei Siebschablonen nicht hinreichend effizient, da zwar die Oberfläche hinreichend gut getrocknet wird, aber nach dem Trocknen noch Flüssigkeitsreste im Bereich von Durchbohrungen verbleiben können.

Bei einer anderen Variante der Trocknung wird Druckluft eingesetzt. Abgesehen davon, dass entsprechende Anlagen aufgrund der hohen Drücke konstruktiv aufwändiger und insoweit kostenintensiv sind, bewirkt die auf den zu trocknenden Gegenstand auftreffende Druckluft aufgrund der sehr hohen Strömungsgeschwindigkeiten ein Abkühlen der zu trocknenden Oberfläche, was die Trocknungseffizienz vermindert.

Aufgabe der Erfindung ist es daher, ein vorbekanntes Säuberungsverfahren bei einer Einzelkammeranlage gemäß dem Oberbegriff von Anspruch 1 hinsichtlich der Säuberungsstufe Trocknen zu verbessern und die vorgenannten Nachteile zu vermeiden.

Diese Aufgabe wird durch den Merkmalen vom kenzeichenden Teil des Anspruchs 1 gelöst. Aufgrund der geringen Strömungsgeschwindigkeiten im Vergleich zur Trocknung mit Druckluft bildet sich infolge der Reibung der durch den Luftverdichter auf vorzugsweise weniger als 1 bar verdichteten Warmluft auf der Oberfläche eine Eigenwärme in der Oberfläche des zu säubernden Gegenstandes, so dass die Oberfläche erwärmt und so die Trocknungseffizienz wesentlich gesteigert werden kann. Aufgrund der geringeren Drücke kann zudem die konstruktive Ausgestaltung der Anlage insbesondere hinsichtlich der Verrohrung im Vergleich zu einer mit Druckluft betriebenen Anlage wesentlich vereinfacht werden.

Das erfindungsgemäße Verfahren eignet sich beispielsweise zum Säubern von Siebschablonen und kann selbstverständlich in Einkammeranlagen durchgeführt werden. Auch das Verfahren des Armes entlang der Oberfläche kann sowohl rotatorisch als auch translatorisch erfolgen.

Zur Säuberung von beispielsweise mit Bauteilen bestückten Leiterplatten bietet sich an, wenn über weitere in ihrer Position oder Ausrichtung veränderbare und in etwa in Richtung des Gegenstandes weisende Austrittsöffnungen eine vorzugsweise demineralisierte Flüssigkeit auf die bereits gereinigte und vorzugsweise gespülte Oberfläche des Gegenstandes mit harten Strahlen gesprüht und/oder Druckluft ausgeblasen wird/werden. So werden die Leiterplatten zunächst gereinigt und vorzugsweise gespült, bevor sie dann im nächsten Schritt mit der vorzugsweise demineralisierten Flüssigkeit besprüht und dann mit Druckluft getrocknet werden. Durch den Einsatz von Druckluft werden auch eventuell hinter den Bauteilen befindliche Flüssigkeitsansammlungen verdrängt. Diese weiteren Austrittsöffnungen können in dem Arm selbst vorgesehen sein. Es ist aber auch durchaus möglich, dass ein separater Arm, z. B. ein in Rotation versetzbarer Rotor, vorgesehen ist.

Im Folgenden werden in den Zeichnungen dargestellte Ausführungsbeispiele der Erfindung erläutert. Es zeigen:
- Fig. 1: einen Schnitt durch eine erfindungsgemäße Vorrichtung einschließlich einer groben Darstellung der Verrohrungen,

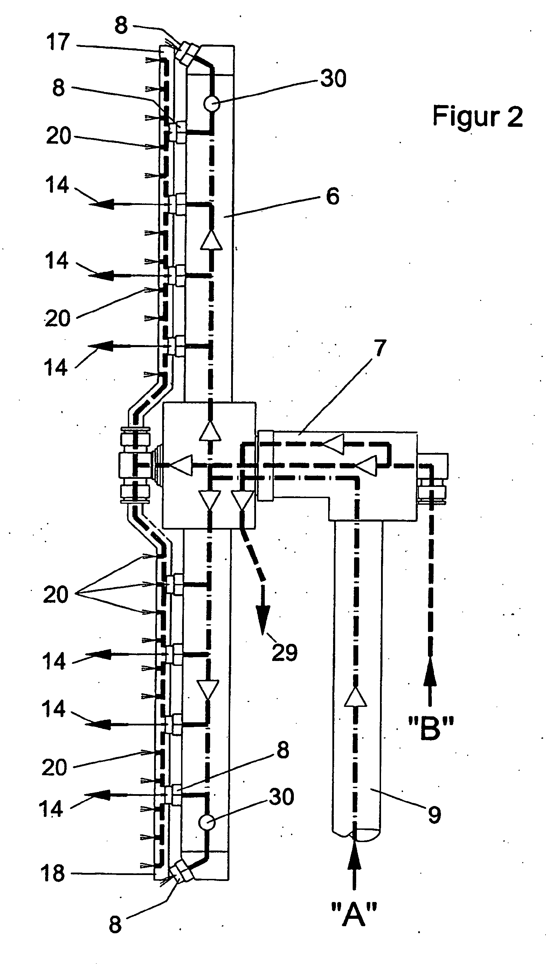

- Fig. 2: eine Vergrößerung eines Armes in der Seitenansicht,
- Fig. 3: eine Draufsicht auf den Gegenstand nach Fig. 2,
- Fig. 4: eine vergrößerte Detailansicht eines Bereichs von Fig. 2 und
- Fig. 5: einen Schnitt durch den Gegenstand nach Fig. 4 in Richtung V-V.

In allen Figuren werden für gleiche bzw. gleichartige Bauteile übereinstimmende Bezugszeichen verwendet.

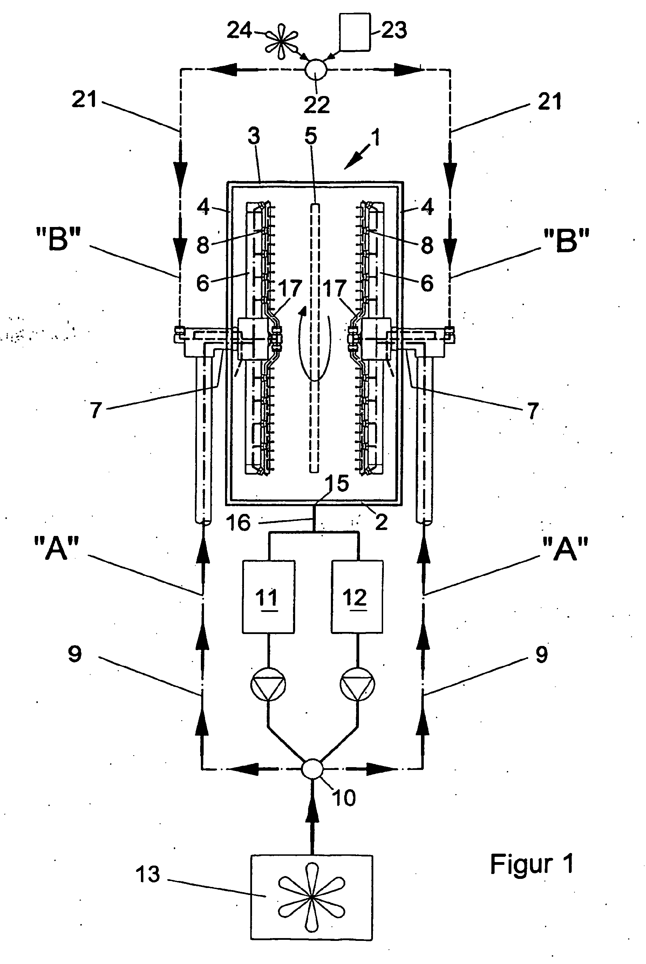

Die in Fig. 1 dargestellte Vorrichtung weist ein Gehäuse 1 auf, das aus je einem Boden- 2, einem Deckenteil 3 und Seitenteilen 4 besteht. Das Gehäuse 1 ist mit einer nicht dargestellten Öffnung öffenbar, durch die der gestrichelt dargestellte Gegenstand 5 in das Gehäuse 1 eingeführt und wieder entnommen werden kann.

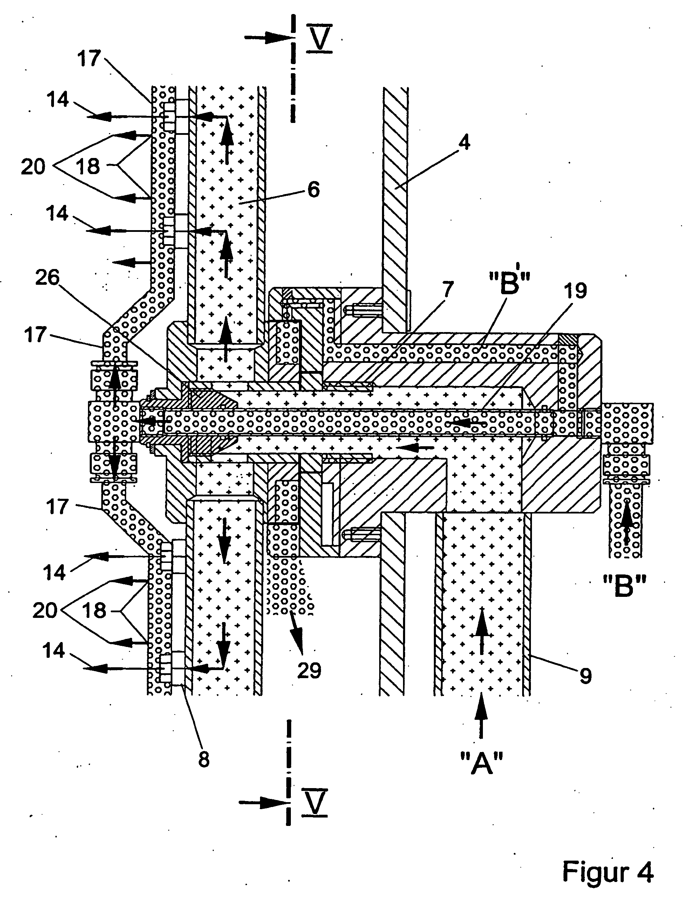

Beidseits der zu säubernden Oberfläche des Gegenstandes 5 ist je ein Arm 6 vorgesehen, der um eine Achse 7, die senkrecht zu der zu säubernden Oberfläche des Gegenstandes 5 ausgerichtet ist, drehbar gelagert ist. Die Achse 7 ist, wie beispielsweise aus Fig. 4 ersichtlich, als Hohlachse ausgebildet.

Der Arm 6 weist mehrere in Richtung der zu säubernden Oberfläche des Gegenstandes 5 weisende Austrittsöffnungen 8 auf. Diese Austrittsöffnungen 8 sind über die als Achse 7 ausgebildete Hohlachse und eine entsprechende Verrohrung 9 mit einer Ventilknotenpunkteinheit 10 verbunden. Die Ventilknotenpunkteinheit 10 selbst ist wiederum mit einem Vorratsbehälter für Reinigungsflüssigkeit 11, einem Vorratsbehälter für Spülflüssigkeit 12 und einem Luftverdichter 13 für Warmluft verbunden. Je nach der Stellung der Ventilknotenpunkteinheit 10 wird entweder Reinigungsflüssigkeit, Spülflüssigkeit oder zum Trocknen auch Warmluft (Pfeil 14) auf den zu säubernden Gegenstand 5 geblasen.

Auf diese Weise wird der zu säubernde Gegenstand 5, z.B. eine Siebschablone, zunächst mit einer Reinigungsflüssigkeit, dann mit einer Spül- bzw. Nachspülflüssigkeit besprüht und anschließend mit Warmluft beaufschlagt werden. Sofern erforderlich, kann die Verrohrung 9 nach dem Reinigungsvorgang und vor dem Spülvorgang mittels Luft noch freigeblasen werden.

Die von dem flächigen Gegenstand 5 abtropfende Flüssigkeit kann getrennt nach Reinigungs- und Spülflüssigkeit in den entsprechenden Vorratsbehälter 11 bzw. 12 über einen bodenseitigen Ablauf 15 und eine entsprechende Verrohrung 16 rückgeführt werden. Mittels der Arme 6 können beispielsweise Siebschablonen gesäubert werden.

Für das Säubern von bestückten Leiterplatten, Baugruppen oder sonstige Gegenständen 5 mit darauf angebrachten Bauteilen ist auf jedem Arm 6 jeweils ein Rotor 17 mit weiteren Austrittsöffnungen 18 vorgesehen. Der Rotor 17 ist auf einer Rotorachse 19 gelagert, die konzentrisch mit der Achse 7 gelagert ist und ebenfalls als Hohlachse ausgebildet ist.

Über die als Hohlachse ausgebildete Rotorachse 19 und die damit verbundenen weiteren Austrittsöffnungen 18 wird nach dem Reinigen und Spülen mittels des Arms 6 eine vorzugsweise demineralisierte Flüssigkeit (Pfeil 20) über die weiteren Austrittsöffnungen 18 des Rotors 17 auf den Gegenstand 5 gesprüht. Zum Trocknen wird dann über die weiteren Austrittsöffnungen 18 Druckluft (Pfeil 20) auf den Gegenstand 5 geblasen, so dass sichergestellt ist, dass auch Flüssigkeit hinter den Bauteilen verdrängt wird.

Die Hohlachse des Rotors 17 ist über eine separate Verrohrung 21 und eine Ventilknotenpunkteinheit 22 mit einem Vorratsbehälter 23 für eine vorzugsweise demineralisierte Flüssigkeit und einer Druckluftquelle 24 verbunden. Je nach Stellung der Ventilknotenpunkteinheit 22 wird entweder Druckluft oder vorzugsweise demineralisierte Flüssigkeit durch die Verrohrung 21 geleitet.

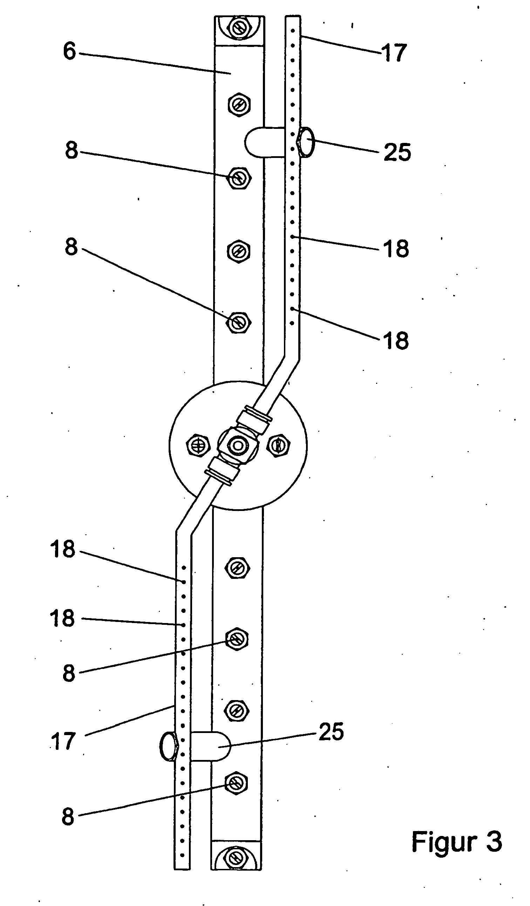

Wie aus Fig.3 zu entnehmen ist, sind die beiden Enden des Rotors 17 im Abstand zur Rotorachse 19 gegeneinander abgewinkelt, wobei die Enden parallel zueinander angeordnet sind. Hierdurch ist gewährleistet, dass der Rotor 17 nicht die Austrittsöffnungen 8 des Arms 6 verdeckt. Mittels Clipsen 25 ist der Rotor 17 gegenüber dem Arm 6 fixiert. Dies hat zur Folge, dass der Arm 6 und der Rotor 17 immer gleichzeitig bewegt werden.

In Fig. 4 ist der Verlauf der Ströme "A" und "B" dargestellt, wobei "A" den Verlauf zu dem Arm 6 für die Reinigungsflüssigkeit, die Spülflüssigkeit bzw. die Warmluft verdeutlichen, während Strom "B" den Verlauf zu dem Rotor 17 für die vorzugsweise demineralisierte Flüssigkeit sowie die Druckluft darstellt.

Wie Fig. 4 zu entnehmen ist, ist die Achse 7 des Arms 6 zum Durchleiten des für die betreffende Säuberungsstufe erforderlichen Mediums als Hohlachse ausgebildet. Dabei weist die Achse 7 im Bereich der Lagerung des Arms 6 einen entgegen die Strömungsrichtung (Pfeil 14) weisenden Kegel 26 zum Umlenken des für die betreffende Säuberungsstufe erforderlichen Mediums in die beiden Enden des Arms 6 auf.

Ebenfalls die Rotorachse 19 ist zum Durchleiten der Druckluft und/oder der vorzugsweise demineralisierten Flüssigkeit als Hohlachse ausgebildet, wobei Rotorachse 19 und Achse 7 koaxial ausgebildet sind. Die Rotorachse 19 steht endseitig aus der Achse 7 hervor.

Sofern die Vorrichtung nur zum Säubern von Siebschablonen und anderen nicht mit Bauteilen bestückten Leiterplatten eingesetzt wird und insoweit kein separater Rotor 17 erforderlich ist, kann die Rotorachse 19 auch als Starrachse ausgebildet sein.

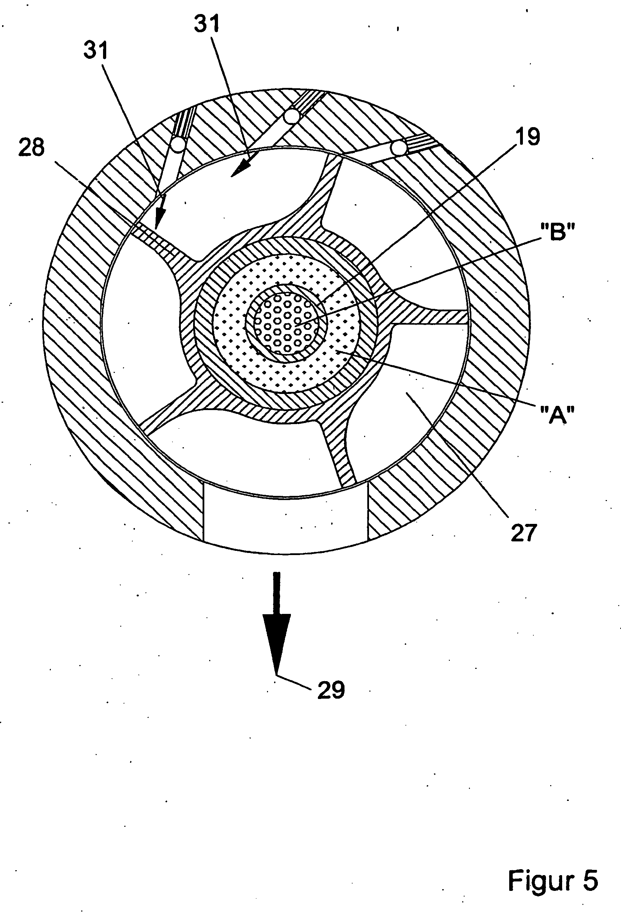

Zum Antrieb des Rotors 17 ist der Rotor 17 mit einem Schaufelrad 27, so wie es in Fig. 5 dargestellt ist, mit umfangsseitigen Schaufeln 28 verbunden. Als Antriebsmedium dient ein Teilstrom "B"' des Stroms "B", der abgezweigt wird und dann tangential (Pfeile 31) auf die Schaufeln 28 geleitet wird. Hierdurch wird der Rotor 17 und somit der Arm 6 in eine Rotationsbewegung versetzt. Der für den Antrieb erforderliche Teilstrom "B'" tritt unterseitig aus der Lagerung wieder aus (Pfeil 29) und wird auf dem Gehäuseboden aufgefangen.

Für den Antrieb des Arms 6 beim Reinigen, Spülen bzw. Trocknen sind in dem Arm 6 Antriebsdüsen 30 vorgesehen, durch die ein Teilstrom der Reinigungs- bzw. Spülflüssigkeit bzw. der Warmluft beispielsweise durch einen Luftverdichter verdichtete Luft in der Rotationsebene ausgeblasen und so der Arm 6 mit dem Rotor 17 in Rotation versetzt wird.

Bei der in Fig. 4 dargestellten Ausführungsform ist die Lagerung direkt an einem Seitenteil 4 des Gehäuses 1 befestigt. Demgegenüber ist bei der Ausführungsform nach Fig. 1 die Lagerung geringfügig von dem Seitenteil 4 beabstandet.

## Patentansprüche

1. Verfahren zur zumindest dreistufigen Säuberung durch Reinigen, Spülen und Trocknen von im Wesentlichen flächigen Gegenständen (5), insbesondere von Siebschablonen und von mit elektronischen Bauteilen bestückten Leiterplatten, durchgeführt in einer Einkamammeranlage mit zumindest einem auf zumindest einer Seite des Gegenstandes (5) im Abstand zu der zu säubernden Oberfläche des Gegenstandes (5) angeordneten Arm (6), der zur Erfassung der gesamten zu säubernden Oberfläche flächig verteilte und/oder in ihrer Position oder Ausrichtung veränderbare und in etwa in Richtung des Gegenstandes (5) weisende Austrittsöffnungen (8) aufweist, wobei Austrittsöffnungen (8) für die einzelnen Säuberungsstufen vorgesehen sind, **dadurch gekennzeichnet, dass** zur Zuführung der in der Säuberungsstufe Trocknen verwendeten Luft ein Luftverdichter eingesetzt wird und über dieselben Austrittsöffnungen (8) des Arms (6) die Säuberungsstufen Reinigen, Spülen und Trocknen erfolgen und die Säuberungstufe Trocknen mittels verdichteter Warmluft erfolgt.

## Claims

1. Method for cleansing in at least three steps by cleaning, rinsing and drying substantially planar objects (5), in particular screen templates and printed circuit boards provided with electronic components, carried out in a single-chamber system with at least one arm (6) located on at least one side of the object (5) at a spacing from the object's (5) surface to be cleansed, said arm having outlet openings (8), which are distributed over the surface area to cover the entire surface to be cleansed and/or are modifiable in their position or orientation and point approximately in the direction of the object (5), wherein outlet openings (8) are provided for the individual cleansing steps, **characterized in that** an air compressor is used to supply the air used in the cleansing step drying, and the cleansing steps cleaning, rinsing and drying are effected via the same outlet openings (8) of the arm (6) and the cleansing step drying is effected by means of compressed hot air.

## Revendications

1. Procédé pour nettoyer en au moins trois étapes des objets essentiellement plats (5), par nettoyage, rinçage et séchage, en particulier des masques de sérigraphie et des cartes imprimées équipées de composants électroniques, mis en oeuvre dans une installation à un seul compartiment avec au moins un bras (6) disposé au moins sur un côté de l'objet (5) à distance de la surface à nettoyer de l'objet (5), bras qui, afin d'embrasser l'ensemble de la surface à nettoyer, présente des ouvertures de sortie (8) surfaciquement réparties et/ou modifiables quant à leur position ou à leur orientation et dirigées approximativement en direction de l'objet (5), sachant que des ouvertures de sortie (8) sont prévues pour les différentes étapes de nettoyage, **caractérisé en ce qu'**on utilise un compresseur d'air pour apporter l'air utilisé au cours de l'étape de séchage et les étapes de nettoyage, rinçage et séchage sont effectuées via les mêmes ouvertures de sortie (8) du bras (6), l'étape de séchage s'effectuant au moyen d'air chaud comprimé.
